# EUROPEAN PATENT APPLICATION

(11) **EP 2 063 462 A1**
(43) Date of publication of application: **27.05.2009**
(21) Application number: 07806775.8
(22) Date of filing: 05.09.2007
(51) Int. Cl.: H01L 21/3065, C01B 33/12, C03C 15/00, H03H 3/02, H03H 3/08, H05H 1/46

(54) **APPARATUS AND METHOD FOR DRY ETCHING**

(30) Priority: 08.09.2006 JP 2006243976
(71) Applicant: ULVAC, INC., Chigasaki-shi, Kanagawa 253-8543 (JP)
(72) Inventor: MORIKAWA, Yasuhiro, Susono-shi, Shizuoka 410-1231 (JP); SUU, Koukou, Susono-shi, Shizuoka 410-1231 (JP)
(74) Representative: AMMANN PATENTANWÄLTE AG BERN
(86) International application number: PCT/JP2007/067333
(87) International publication number: WO 2008/029854

(57) **Abstract**

The present invention herein provides an apparatus and a method for dry etching, which can solve such a problem that an object to be processed undergoes cracking during the etching procedures due to the heat deformation thereof and thermal shocks, possibly encountered when subjecting, to dry etching procedures, the object having a high thermal expansion coefficient. A dry etching apparatus is provided with an electrode structure having a convex-shaped surface, the convex-shape is one concentric with the cross section of the electrode structure and the height thereof falls within the range of from 0.2 to 1.0 mm. An object consisting of a material having a thermal expansion coefficient of not less than 30×10⁻⁷/°C is subjected to dry etching while using the foregoing dry etching apparatus.

## Description

### Technical Field

The present invention relates to an apparatus and a method for dry etching and more particularly to a dry etching apparatus equipped with an electrode structure having a convex-shaped surface as well as a dry etching method which makes use of the apparatus.

### Background Art

There have recently been required for the development of high precision techniques for processing materials such as quartz crystals, quartz and glass substances when producing, for instance, a subminiature quartz crystal oscillator such as a tuning fork-type quartz crystal oscillator and a thickness-shear mode quartz crystal resonator, an electrode, an element for optical applications, a surface acoustic wave device (an SAW device), a micro-sensor, and a micro-actuator and accordingly, it has gradually been difficult for the existing processing techniques, which have been conducted under wet conditions, to satisfy the foregoing requirements for the further precise processing.

For this reason, it would be considered to be effective to use the processing methods which make use of the dry etching technique, but such dry etching technique may suffer from such a problem that materials each having a high thermal expansion coefficient such as quartz crystal, quartz and glass materials are liable to undergo heat deformation due to the action of temperatures used in the dry etching processes. In some cases, the object to be processed would sometimes undergo cracking during the etching procedures due to such heat deformation of the object and thermal shocks acting on the same.

However, there has not yet been proposed any satisfactory technique for the solution of such a problem that an object to be processed undergoes cracking during the etching procedures due to such heat deformation and thermal shocks, possibly encountered when subjecting, to dry etching procedures, the object to be processed, which has a high thermal expansion coefficient.

For instance, a method has been known, in which a quartz crystal oscillator is produced according to the photolithography techniques and the chemical etching technique (see, for instance, Patent Document 1 specified below), but this method cannot always solve the foregoing problem.
Patent Document 1: Japanese Un-Examined Patent Publication Hei 5-315881 (see the section entitled "What is claimed is").

### Disclosure of the Invention

### Problems That the Invention is to Solve

It is an object of the present invention to solve the problems associated with the conventional dry etching techniques and more particularly to provide an apparatus and a method for dry etching, which can solve such a problem that an object to be processed undergoes cracking during the etching procedures due to the heat deformation thereof and thermal shocks acting on the same, possibly encountered when subjecting, to dry etching procedures, the object to be processed, which has a high thermal expansion coefficient.

### Means for Solving the Problems

The dry etching apparatus according to the present invention is **characterized in that** it is provided with an electrode structure having a convex-shaped surface. The use of such an electrode structure would permit the solution of the problem such that the object to be processed undergoes cracking during its dry etching because of the heat deformation thereof and thermal shocks acting thereon during the same.

The convex shape of the electrode structure used herein is **characterized in that** it means one concentric with the cross section of the structure and the height thereof falls within the range of from 0.2 to 1.0 mm. In this respect, if the height of the convex shape as measured from the bottom face thereof is less than 0.2 mm, there is observed a difference in temperature between the central and peripheral portions on the object to be processed during the etching procedures of the same or the temperature distribution on the surface thereof (i.e. the in-plane temperature distribution) becomes non-uniform and this in turn results in the heat deformation and cracking of the object. On the other hand, if the height of the convex shape as measured from the bottom face thereof is greater than 1.0 mm, the object may sometimes be cracked upon the chucking thereof to an electrode structure.

The dry etching apparatus according to the present invention has the following construction: a plasma-generation section is positioned within and at the upper portion of a vacuum chamber and a substrate electrode section is positioned within and at the bottom portion of the vacuum chamber; a high-frequency antenna coil for generating plasma, which is connected to a first high-frequency power source, is attached to the outside of the side wall of the plasma-generation section, which is constituted by a dielectric material; an electrode structure, to which a high-frequency bias electric power is applied through a second high-frequency power source, is fitted to the substrate electrode section; a counter (or opposite) electrode is arranged within the plasma-generation section in such a manner that it is opposed to the electrode structure; the counter or opposite electrode is a float electrode which is so designed that it is air-tightly fixed, through an insulator, preferably to an upper flange of the side wall of the plasma-generation section and that it is in a potentially floating state; and a magnetic field-establishing coil is positioned on the outside of the high-frequency antenna coil, and the dry etching apparatus is **characterized in that** the electrode structure has a convex-shaped surface. The convex shape of the electrode structure used herein is **characterized in that** it means one concentric with the cross section of the electrode structure and the height thereof falls within the range of from 0.2 to 1.0 mm. If the height of the convex shape is beyond the range specified above, the problems described above would arise.

Alternatively, the dry etching apparatus according to the present invention has the following construction: a plasma-generation section is positioned within and at the upper portion of a vacuum chamber and a substrate electrode section is positioned within and at the bottom portion of the vacuum chamber; a high-frequency antenna coil for generating plasma, which is connected to a first high-frequency power source, is attached to the outside of the side wall of the plasma-generation section, which is constituted by a dielectric material; an electrode structure, to which a high-frequency bias electric power is applied through a second high-frequency power source, is fitted to the substrate electrode section; a counter (or opposite) electrode is arranged within the plasma-generation section in such a manner that it is opposed to the electrode structure; the counter or opposite electrode is a float electrode which is so designed that it is air-tightly fixed, through an insulator, preferably to an upper flange of the side wall of the plasma-generation section and that it is in a potentially floating state; a magnetic field-establishing coil is positioned on the outside of the high-frequency antenna coil; and a variable condenser, which can serve as a branching device, is arranged in the course of an electric power supply path positioned between the antenna coil and the first high-frequency power source so as to ensure the connection of the first high-frequency power source with the counter electrode; and the dry etching apparatus is **characterized in that** the electrode structure has a convex-shaped surface. The convex shape of the electrode structure used herein is **characterized in that** it means one concentric with the cross section of the electrode structure and the height thereof falls within the range of from 0.2 to 1.0 mm. If the height of the convex shape is beyond the range specified above, the problems described above would arise.

The dry etching method according to the present invention comprises the step of subjecting, to dry-etching, an object to be processed, which is made of a material having a thermal expansion coefficient of not less than 30×10⁻⁷/°C using the dry etching apparatus discussed above. There was not observed any cracking of the processed article thus obtained due to the heat deformation thereof and thermal shocks acting on the same, possibly encountered when an object to be processed is subjected to dry etching. The object to be processed is one made of, for instance, a quartz, quartz crystal or glass material.

### Effects of the Invention

According to the present invention, the surface shape of an electrode structure to be incorporated into a dry etching apparatus is so designed that it has a convex shape and accordingly, the present invention permits the solution of such a problem that an obj ect to be processed undergoes cracking during its dry etching because of the heat deformation thereof and thermal shocks acting on the same, possibly encountered when subjecting an object to be processed having a high thermal expansion coefficient to a dry etching step.

### Brief Description of the Drawings

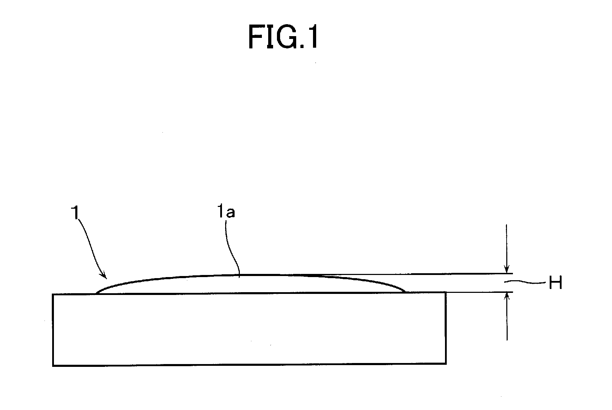

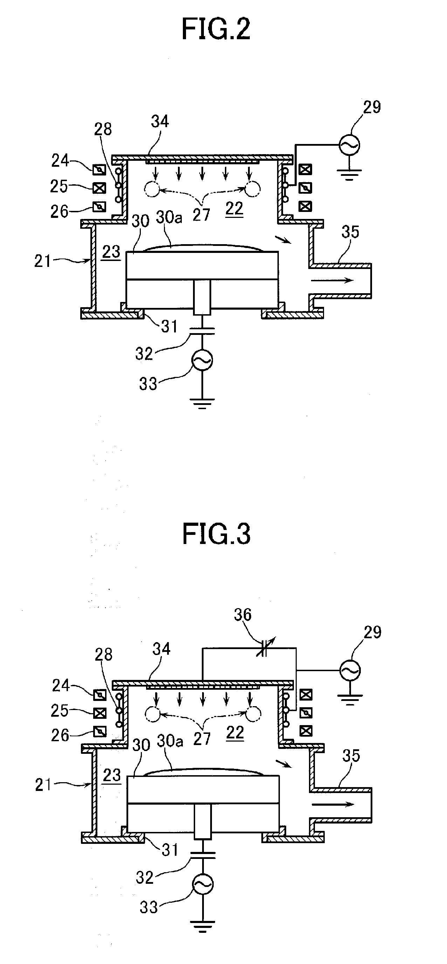

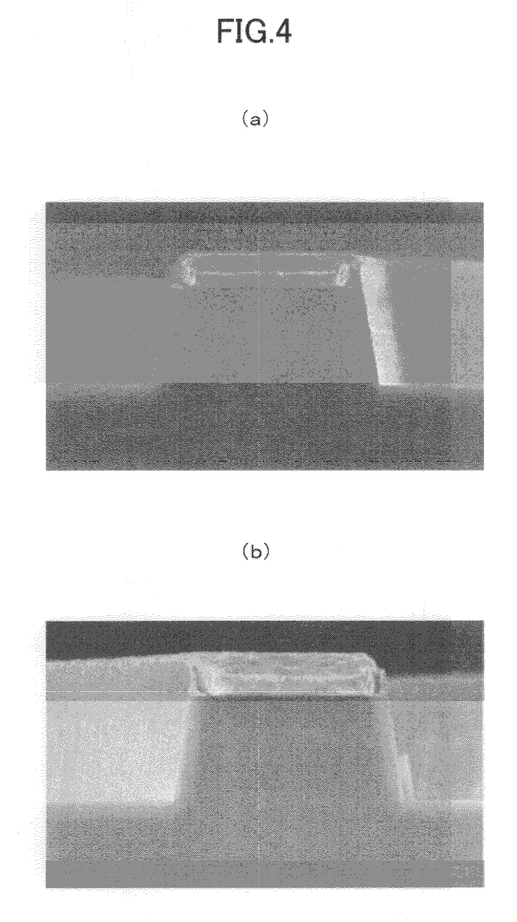

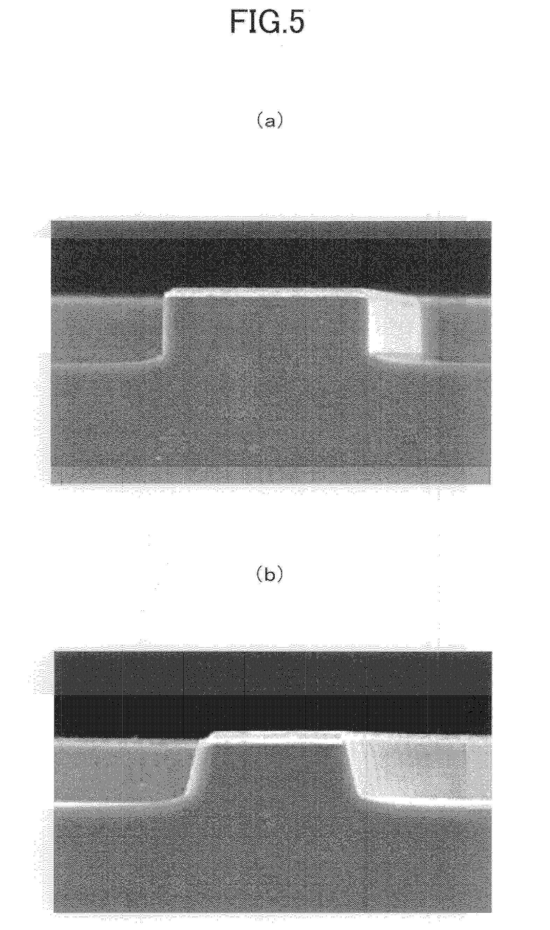

Fig. 1 is a side view of the electrode structure used in the dry etching apparatus according to the present invention; Fig. 2 is a cross-sectional view schematically showing the construction of the dry etching apparatus according to an embodiment of the present invention; Fig. 3 is a cross-sectional view schematically showing the construction of the dry etching apparatus according to another embodiment of the present invention; Fig. 4 shows SEM images each illustrating the cross section of a dry-etched substrate processed using the dry etching apparatus according to the present invention, wherein Fig. 4 (a) is the SEM image showing the central portion of the dry-etched substrate and Fig. 4(b) is the SEM image showing the edge portion thereof; and Fig. 5 shows SEM images each illustrating the cross section of a dry-etched substrate processed using a conventional dry etching apparatus, wherein Fig. 5(a) is the SEM image showing the central portion of the dry- etched substrate and Fig. 5(b) is the SEM image showing the edge portion thereof.

### Best Mode for Carrying Out the Invention

The dry etching apparatus according to the present invention is used for dry etching an object to be processed, which is made of a material having a thermal expansion coefficient of not less than 30×10⁻⁷/°C, under the conventionally known process conditions. In this apparatus, the surface of the electrode structure to be exposed to a heat source such as a plasma source is so designed that it has a convex-shaped surface. The term "convex-shaped surface" herein used means a curved surface having a desired curvature. More particularly, the dry etching apparatus according to the present invention is one equipped with an electrode structure in which the height of the convex-shaped portion or that as measured from the center of curvature thereof ranges from 0.2 to 1.0 mm.

The electrode structure is so designed that it has a surface shape capable of coping with the direction along which an object to be processed, as a substrate, is warped or bent due to the action of heat, for instance, that originated from the plasma and accordingly, any significant stress is not applied, at all, onto the object during the etching procedures. For this reason, such a construction of the electrode structure would permit not only the solution of such problem that the object to be processed undergoes any deformation and cracking during its dry etching, but also the improvement of the uniformity of the temperature distribution on the processed surface of the object, i.e. the uniformity of the in-plane temperature distribution of the object, and the uniformity of shape of the etched object and therefore, the present invention permits the highly precise processing through etching of an object having a large surface area.

The electrode structure 1 which is fitted to the dry etching apparatus of the present invention is one having a convex-shaped surface with respect to the object to be processed, and having a cross section as schematically shown in Fig. 1. The electrode structure 1 has a convex-shaped portion 1a which is concentric with respect to the plasma heat source. The object to be processed is preferably placed on the electrode structure in such a manner that the center of the former is in agreement with that of the convex-shaped portion. The convex-shaped portion is so designed that the height of the peak of the portion (in other words, the height of the central point thereof) falls within the range of from 0.2 to 1.0 mm and the portion is preferably provided, on the exterior of the outer periphery of the bottom thereof, with a margin for clamping the object to be processed (the size of the margin may vary depending on the size of the object to be processed, but is preferably on the order of about 5 mm for an object having a size of 10 cm) in order to fix the object to the electrode structure by means of a chucking means such as a mechanical clamp.

If using a conventional electrode structure whose surface is not in any convex-shaped form, but in a leveled shape, the object to be processed undergoes deformation and/or cracking during its dry etching because of the action of the heat delivered from a heat source such as a plasma heat source. This in turn makes, non-uniform, the temperature distribution on the plane of the object to be processed, the shape of the etched object would be non-uniform and therefore, any highly precise etching of an object cannot be expected at all.

The obj ect to be processed using the dry etching apparatus according to the present invention may be any one insofar as it is made of a material having a thermal expansion coefficient of not less than 30×10⁻⁷/°C. For example, such materials include those made of quartz, quartz crystals (both naturally occurring and synthetic ones), glass and sapphire. Specific examples of glass materials are those each having a thermal expansion coefficient specified above such as various kinds of soda glass, borosilicate glass, potash glass, soda-potash glass, lithium silicate glass and optical glass.

The thickness of the object to be processed is preferably not more than 600 µm. This is because if the thickness thereof exceeds 600 µm, the object is highly liable to cause cracking during its etching. On the other hand, the lower limit thereof is not specifically specified, but it would be sufficient for the achievement of the intended purpose of the present invention to use objects commercially available.

As has been discussed above, it is preferred that the dry etching apparatus of the present invention has the following construction: a plasma-generation section is positioned within and at the upper portion of a vacuum chamber and a substrate electrode section is positioned within and at the bottom portion of the vacuum chamber; a high-frequency antenna coil for generating plasma, which is connected to a first high-frequency power source, is attached to the outside of the side wall of the plasma-generation section, which is constituted by a dielectric material; a substrate electrode structure, to which a high-frequency bias electric power is applied through a second high-frequency power source, is fitted to the substrate electrode section; a counter (or opposite) electrode is arranged within the plasma-generation section in such a manner that it is opposed to the substrate electrode structure; the counter or opposite electrode is a float electrode which is so designed that it is air-tightly fixed, through an insulator, preferably to an upper flange of the side wall of the plasma-generation section and that it is in a potentially floating state; and a magnetic field-establishing coil is positioned on the outside of the high-frequency antenna coil; and the dry etching apparatus is further designed such that the electrode structure has a convex-shaped surface concentric with the cross section of the structure and that the height of the convex-shaped portion thereof falls within the range of from 0.2 to 1.0 mm. The use of an etching apparatus provided with an electrode structure having the foregoing construction would permit the etching of an object while ensuring the achievement of the foregoing effects.

The dry etching apparatus according to the present invention will now be described in more detail below while taking an NLD etching apparatus as an example of the etching apparatus of the present invention discussed above, while referring to the accompanying figures 2 and 3. The following are description of such an NLD etching apparatus and the etching method using the same, but it is a matter of course that the etching apparatus used herein may be any one, such as an etching apparatus which is free of any magnetic field-establishing coil or a sputtering apparatus insofar as the etching apparatus or the sputtering apparatus is provided with an electrode structure whose surface is in a convex shape as has been described above.

Fig. 2 shows the schematic construction of a magnetic neutral loop discharge type etching apparatus. This etching apparatus comprises a vacuum chamber 21, the upper portion of which constitutes a plasma-generating section 22 formed by a cylindrical wall of a dielectric material and the lower portion of which constitutes a substrate electrode portion 23. An annular magnetic neutral loop 27 is formed within the plasma-generating section 22 by the action of three magnetic field-establishing coils 24, 25 and 26 which are arranged on the outside of the wall (the side wall of the dielectric material) of the plasma-generating section 22. A high-frequency antenna coil 28 for generating plasma is arranged between the magnetic field-establishing coils 24, 25 and 26 and the outside of the side wall of the dielectric material and the high-frequency antenna coil 28 is connected to a high-frequency power supply source 29 and it is so designed that an alternating electric field is established along the magnetic neutral loop 27 formed by the magnetic field-establishing coils to thus generate discharge plasma within the magnetic neutral loop.

An electrode structure 30, which is in a parallel relation with respect to the plane formed by the magnetic neutral loop 2 7, is positioned, through a member 31 of a dielectric material, within the lower substrate electrode portion 23. The electrode structure 30 has a convex-shaped portion 30a on its surface; is connected, through a blocking condenser 32, to a high-frequency power supply source 33 for applying a high-frequency bias electric power to the electrode structure; and potentially serves as a float electrode because of the presence of the blocking condenser 32 to thus establish a negative bias potential. In addition, a roof 34 of the plasma-generating section 22 is air-tightly attached to an upper flange on the side wall of the dielectric body to thus form a counter electrode. A shower plate equipped with a gas-introduction port for the introduction of an etching gas into the vacuum chamber 21 is fitted to the roof 34 and this gas-introduction port is not shown in this figure, but is connected to an etching gas-supply source through a gas-supply passage and a gas flow rate-controlling unit for controlling the flow rate of the etching gas. The substrate electrode portion 23 is provided with an exhaust port 35.

Fig. 3 shows another embodiment of the NLD etching apparatus according to the present invention. All the constitutional elements of this embodiment, which are identical to those of the embodiment as shown in Fig. 2, bear the same reference numerals. The etching apparatus as shown in Fig. 3 comprises, like the embodiment shown in Fig. 2, a vacuum chamber 21, the upper portion of which constitutes a plasma-generating section 22 formed by a cylindrical wall of a dielectric material and the lower portion of which constitutes a substrate electrode portion 23. In this connection, an annular magnetic neutral loop 27 is formed within the plasma-generating section 22 by the action of magnetic field-establishing coils (in this figure, there are depicted three such coils 24, 25 and 26) which are arranged on the outside of the side wall (the side wall of the dielectric material) of the plasma-generating section 22. A high-frequency antenna coil 28 for generating plasma is arranged between the magnetic field-establishing coils 24, 25 and 26 and the outside of the side wall of the dielectric material and the high-frequency antenna coil 28 is connected to a first high-frequency power supply source 29 and it is so designed that an alternating electric field is established along the magnetic neutral loop 27 formed by the magnetic field-establishing coils to thus generate discharge plasma within the magnetic neutral loop.

An electrode structure 30, which has, as has been discussed above, a convex-shaped portion 30a on its surface, is positioned within the lower substrate electrode section 23 through a member 31 made of a dielectric material, in a parallel relation to the plane formed by the magnetic neutral loop 27. The electrode structure 30 is connected, through a blocking condenser 32, to a second high-frequency power supply source 33 for applying a high-frequency bias electric power to the electrode structure; and potentially serves as a float electrode because of the presence of the blocking condenser 32 to thus establish a negative bias potential. In addition, a roof 34 of the plasma-generating section 22 is air-tightly attached to an upper flange on the side wall of the dielectric body to thus form a counter electrode. A shower plate equipped with a gas-introduction port for introducing an etching gas into the vacuum chamber 21 is fitted to the roof 34 and this gas-introduction port is not shown in this figure, but is connected to an etching gas-supply source through a gas-supply passage and a gas flow rate-controlling unit for controlling the flow rate of the etching gas. The substrate electrode portion 23 is provided with an exhaust port 35.

The etching apparatus as shown in Fig. 3 is a two-frequency discharge type etching apparatus. As has been described above, this etching apparatus is so designed that a grounding electrode arranged at a position opposite to the electrode structure 30 can serve as a counter electrode in a potentially floating state due to the presence of a dielectric material and that a weak high-frequency bias electric power can be applied to this counter electrode (the roof 34). The etching apparatus is likewise so designed that a branch path is disposed at any position in the course of the power-supply passage extending from the high-frequency power source 29 for generating plasma to the high-frequency antenna coil 28 for generating an induction discharge and that a part of the high-frequency electric power for the inductive discharge is branched and applied to the counter electrode through a variable condenser 36 positioned in the branch path to thus make the counter electrode generate a self-bias.

Alternatively, the etching apparatus as shown in Fig. 3 and equipped with the variable condenser 36 may be provided with a mechanism capable of variously controlling and changing the capacity of the variable condenser by the action of a driving unit so that the voltage to be applied to the counter electrode 34 can be set at a level falling within a desired range.

As has been described above, the etching apparatus according to this embodiment is so designed that the high-frequency electric power can be branched and applied to the roof 34 capable of serving as a counter electrode, through the variable condenser 36 having an incorporated capacity-control unit. In other words, the etching apparatus according to this embodiment is provided with such a variable condenser 36 that can serve to change the voltage from the high-frequency power supply source 29 to be applied to the roof 34 (counter electrode) through the branch path. Alternatively, the etching apparatus may likewise be provided with a mechanism for ensuring and establishing a voltage, of a predetermined level (for instance, 1800 V), to be applied to the high-frequency antenna coil 28 for the generation of an induction discharge.

The etching apparatus having such a structure as that described above has a simple structure and it is not expensive; it never suffers from such a problem that high-frequency electric fields applied thereto make interference with one another; and it permits the formation of plasma at a high efficiency. In addition, the etching apparatus permits the application of a desired high-frequency voltage to the roof serving as a counter electrode. Therefore, the etching apparatus in which the high-frequency electric power is branched by branching the electric power-supply passage of the high-frequency power supply source 29 connected to the antenna coil 28 so that a part of the high-frequency electric power can be branched and applied, through the variable condenser 36, to a floating electrode for Faraday shield (or electrostatic shielding) arranged in the interior of the antenna coil may be designed in the same manner used in the aforementioned system in which the roof can serve as a float electrode, to thus carry out the same etching procedures. This float electrode for Faraday shield or the like can likewise be positioned in the interior of the high-frequency antenna coil.

The foregoing Faraday shield may be any known one and may be, for instance, a metal plate wherein a plurality of slits are formed in a parallel relation and an antenna coil is perpendicularly disposed in the middle of the slit and in the longitudinal direction thereof. Metal edges are arranged at the both ends of the slit in the longitudinal direction thereof in order to make the potential of the strip-like metal plate identical. The electrostatic field of the antenna coil is shielded by the metal plate, but the induced magnetic field is not shielded by the same. This induced magnetic field is thus established within the plasma to thus form an induced electric field. The width of each slit may appropriately be determined depending on each particular purpose, it in general ranges from about 0.5 to 10 mm, but it is usually sufficient to use a slit having a width ranging from 1 to 2 mm. The use of a wider slit is not preferred since the electrostatic field may undergo penetration to some extent. Thus, the width of each slit is set at a level on the order of about 2 mm.

The present invention will hereunder be described in more specifically with reference to the following Examples.

### Example 1

The etching process comprising the following steps was conducted using an NLD etching apparatus as shown in Fig. 2, which was equipped with an electrode structure having a convex shape as shown in Fig. 1.

An object used herein as a substrate to be processed was a quartz crystal having a thermal expansion coefficient of 71×10⁻⁷/°C and a thickness of 500 µm. The substrate was fixed to the electrode structure having such a convex-shaped surface (the height of the convex shape was found to be 0.5 mm) using a mechanical clamp in such a manner that the center of the substrate was in agreement with that of the convex-shaped portion and then He gas was charged in the space formed between the electrode structure and the substrate to a desired pressure (400 Pa).

The substrate was etched by the introduction of an etching gas (C₄F₈ gas) under etching process conditions such as a high-frequency power source 29 (13.56 MHz) for the plasma-generation at an electric power of 1800 W (antenna power) and a high-frequency power source 33 (12.56 MHz) for the substrate-biasing at an electric power of 400 W (bias power), while inducing discharges under a pressure of 0.67 Pa at a preset substrate temperature of 20°C for a predetermined period of time.

Any deformation and/or cracking of the substrate possibly observed during the etching procedures were examined simply by monitoring the flow rate of He gas which was brought into contact with the back of the substrate as already discussed above. In this Example, there was not observed any deformation and/or cracking of the substrate during the etching procedures.

In addition, as the results of the etching of the substrate, the SEM images of the cross sections of the substrate thus etched are shown in Figs. 4 (a) and (b). In this connection, Fig. 4(a) is the SEM image showing the shape of the central portion of the etched substrate and Fig. 4 (b) is the SEM image showing the shape of the edge portion of the etched substrate. As will be clear from the results shown in Fig. 4, the use of an electrode structure having a convex-shaped surface permitted the formation of an etched substrate which is free of any variations in or any scattering of the etched substrate surface throughout the surface thereof.

Moreover, it was found that the temperature distribution within the substrate surface was uniform throughout the etching procedures.

### (Comparative Example 1)

The same etching procedures used in Example 1 were repeated except for using, as the dry etching apparatus, conventional one provided with an electrode structure having a flat surface.

In the foregoing etching procedures, it was found that there was observed the occurrence of heat deformation and that the etched substrate was thus deformed.

In addition, as the results of the etching of the substrate, the SEM images of the cross sections of the substrate thus etched are shown in Figs. 5(a) and (b). In this connection, Fig. 5(a) is the SEM image showing the shape of the central portion of the etched substrate and Fig. 5(b) is the SEM image showing the shape of the edge portion of the etched substrate. As will be clear from the results shown in Fig. 5, the use of an electrode structure having a flat surface results in the formation of etched surface which differs in the etched surface shape between the central and edge portions of the same and there is observed variations in or scattering of the etched surface shape throughout the surface thereof.

Moreover, as to the temperature distribution within the substrate surface during the etching procedures, it was found that the temperature at the central portion of the substrate was considerably higher than that observed at the edge portion thereof. In other words, the temperature distribution within the substrate surface was found to be non-uniform.

### (Comparative Example 2)

The same etching procedures used in Example 1 were repeated except for using, as the substrate, a glass substrate having a thermal expansion coefficient of 20×10⁻⁷/°C. As a result, it was found that the substrate underwent heat deformation during the etching procedures and that it was simultaneously underwent cracking.

### Example 2

The same etching procedures used in Example 1 were repeated except that CF₄ gas was substituted for the C₄F₈ gas used in Example 1 to thus etch the substrate. As a result, it was found that the same results observed in Example 1 were obtained.

### Example 3

The same etching procedures used in Example 1 were repeated except for using, as a substrate, a quartz crystal having a thermal expansion coefficient of 132×10⁻⁷/°C. As a result, it was found that the results obtained were the same as those observed in Example 1.

### Industrial Applicability

According to the present invention, the surface shape of an electrode structure to be arranged within a dry etching apparatus is so designed that it has a convex shape and accordingly, the present invention permits the solution of such a problem that an object to be processed, which has a high thermal expansion coefficient, undergoes cracking during its dry etching because of the heat deformation thereof and thermal shocks acting thereon, possibly encountered when subjecting the object to a dry etching step. Accordingly, the present invention can be applied to a technical field wherein an object to be processed such as quartz crystal, quartz or glass substance, which has a high thermal expansion coefficient, is subjected to dry etching to thus form, for instance, a subminiature quartz crystal oscillator such as a tuning fork-type quartz crystal oscillator and a thickness-shear mode quartz crystal resonator, an electrode, an element for optical applications, a surface acoustic wave device (an SAW device), a micro-sensor, and a micro-actuator.

## Claims

1. A dry etching apparatus **characterized in that** it is provided with an electrode structure having a convex-shaped surface.

2. The dry etching apparatus as set forth in claim 1, wherein the convex-shape is one concentric with a cross section of the electrode structure and its height falls within the range of from 0.2 to 1.0 mm.

3. A dry etching apparatus having the following construction: a plasma-generation section is positioned within and at the upper portion of a vacuum chamber and a substrate electrode section is positioned within and at the bottom portion of the vacuum chamber; a high-frequency antenna coil for generating plasma, which is connected to a first high-frequency power source, is attached to an outside of a side wall of the plasma-generation section, which is constituted by a dielectric material; an electrode structure, to which a high-frequency bias electric power is applied through a second high-frequency power source, is fitted to the substrate electrode section; a counter electrode is arranged within the plasma-generation section in such a manner that it is opposed to the electrode structure; and a magnetic field-establishing coil is positioned on an outside of the high-frequency antenna coil, wherein the electrode structure has a convex-shaped surface.

4. The dry etching apparatus as set forth in claim 3, wherein the convex-shape is one concentric with the cross section of the electrode structure and the height thereof falls within the range of from 0.2 to 1.0 mm.

5. A the dry etching apparatus having the following construction: a plasma-generation section is positioned within and at the upper portion of a vacuum chamber and a substrate electrode section is positioned within and at the bottom portion of the vacuum chamber; a high-frequency antenna coil for generating plasma, which is connected to a first high-frequency power source, is attached to an outside of a side wall of the plasma-generation section, which is constituted by a dielectric material; an electrode structure, to which a high-frequency bias electric power is applied through a second high-frequency power source, is fitted to the substrate electrode section; a counter electrode is arranged within the plasma-generation section in such a manner that it is opposed to the electrode structure; a magneticfield-establishing coil is positioned on an outside of the high- frequency antenna coil; and a variable condenser serving as a branching device is arranged in the course of an electric power supply path positioned between the antenna coil and the first high-frequency power source so as to ensure the connection of the first high-frequency power source with the counter electrode, wherein the electrode structure has a convex-shaped surface.

6. The dry etching apparatus as set forth in claim 5, wherein the convex-shape is one concentric with the cross section of the electrode structure and the height thereof falls within the range of from 0.2 to 1.0 mm.

7. A dry etching method comprising the step of dry etching an object to be processed, which consists of a material having a thermal expansion coefficient of not less than 30×10⁻⁷/°C using a dry etching apparatus as set forth in any one of claims 1 to 6.

8. The dry etching method as set forth in claim 7, wherein the object to be processed is one consisting of a quartz, quartz crystal or glass material.
